# EUROPEAN PATENT APPLICATION

(11) **EP 2 849 215 A1**
(43) Date of publication of application: **18.03.2015**
(21) Application number: 13787732.0
(22) Date of filing: 24.04.2013
(51) Int. Cl.: H01L 21/368, C01G 29/00, C01G 30/00, H01L 31/0248, H01L 51/42

(54) **COATING LIQUID FOR FORMING SULFIDE SEMICONDUCTOR, SULFIDE SEMICONDUCTOR THIN FILM, AND THIN FILM SOLAR CELL**

(30) Priority: 07.05.2012 JP 2012106082
(71) Applicant: Sekisui Chemical Co., Ltd., Osaka-shi, Osaka 530-0047 (JP)
(72) Inventor: ITO Kazushi, Mishima-gun, Osaka 618-0021 (JP); HAYAKAWA Akinobu, Mishima-gun, Osaka 618-0021 (JP); OHARA Shunji, Mishima-gun, Osaka 618-0021 (JP); SUN Ren-de, Mishima-gun, Osaka 618-0021 (JP)
(74) Representative: Hart-Davis, Jason
(86) International application number: PCT/JP2013/062028
(87) International publication number: WO 2013/168567

(57) **Abstract**

The present invention aims to provide a sulfide semiconductor-forming coating liquid capable of easily forming a sulfide semiconductor having a large area, the sulfide semiconductor being useful as a semiconductor material for photoelectric conversion materials. The present invention also aims to provide a sulfide semiconductor thin film produced using the sulfide semiconductor-forming coating liquid; and a thin film solar cell. The present invention provides a sulfide semiconductor-forming coating liquid, the coating liquid containing a complex containing a metal element of group 15 of the periodic table and sulfur.

## Description

### TECHNICAL FIELD

The present invention relates to a sulfide semiconductor-forming coating liquid for forming a semiconductor suitable as a semiconductor material for photoelectric conversion elements such as solar cells. The present invention also relates to a sulfide semiconductor thin film produced using the sulfide semiconductor-forming coating liquid; and a thin film solar cell.

### BACKGROUND ART

Sulfide semiconductors such as antimony sulfide (Sb₂S₃) and bismuth sulfide (Bi₂S₃), which have a band gap of 1.0 to 2.5 eV, exhibit high light absorption properties in the visible light region. These sulfide semiconductors are promising materials for use as photoelectric conversion materials for solar cells or visible-light-responsive photocatalyst materials. Such semiconductors are also eagerly studied for use in infrared radiation sensors due to their high light permeability in the infrared region. Further, sulfide semiconductors have drawn attention as photoconductive materials as they exhibit changes in the electric conductivity when illuminated by light.

Thin films of the sulfide semiconductor have been manufactured by, for example, the vacuum deposition method, the sputtering method, the gas phase reaction (CVD) method, or the like. Non-Patent Literature 1, for example, reports a method of producing an antimony sulfide thin film by the sputtering method. It teaches that, in this method, the film is amorphous (band gap: 2.24 eV) immediately after the film is formed, and the amorphous film is fired at 400°C under a sulfur atmosphere to provide a crystal film (band gap: 1.73 eV).

Non-Patent Literature 2 discloses a method of producing a sulfide thin film by the electrochemical deposition method. By this method, a thin film with a band gap of 1.58 eV (Sb₂S₃) and a thin film with a band gap of 1.74 eV (Bi₂S₃) are obtained.

However, methods such as the vacuum deposition method and the sputtering method need expensive apparatus and have a disadvantage in terms of the cost. In addition, it is difficult with these methods to form a large area film. Though in the electrochemical deposition method films can be formed at normal temperatures without vacuum equipment, this method can be employed only for forming a film on conductive substrates.

### CITATION LIST

### Non-Patent Literature

Non-Patent Literature 1: Matthieu Y. Versavel and Joel A. Haber, Thin Solid Films, 515(18), 7171-7176 (2007)
Non-Patent Literature 2: N. S. Yesugade, et al., Thin Solid Films, 263(2), 145-149 (1995)

### SUMMARY OF INVENTION

### - Technical Problem

In view of the above situation in the art, the present invention aims to provide a sulfide semiconductor-forming coating liquid capable of easily forming a sulfide semiconductor having a large area, the sulfide semiconductor being useful as a semiconductor material for photoelectric conversion materials. The present invention also aims to provide a sulfide semiconductor thin film produced using the sulfide semiconductor-forming coating liquid; and a thin film solar cell.

### - Solution to Problem

The present invention provides a sulfide semiconductor-forming coating liquid containing a complex containing a metal element of group 15 of the periodic table and sulfur. The present invention will be described in more detail below.

The inventors considered that with a sulfide semiconductor-forming coating liquid (i.e., a precursor solution of a sulfide semiconductor) containing a metal-containing compound and sulfur-containing compound, a sulfide semiconductor having a large area can be easily formed because printing methods can be employed. However, some combinations of metal-containing compounds, sulfur-containing compounds, and solvents for dissolving these compounds tend to cause surface roughness of the sulfide semiconductor film. This in some cases results in lowering of electric characteristics and semiconductor properties. Moreover, it is difficult with such a method to achieve highly reproducible formation of film.

It has been found by the inventors as a result of keen examinations that, in the coating liquid containing a metal-containing compound and a sulfur-containing compound, use of such a metal-containing compound and a sulfur-containing compound as form a complex containing a metal element and sulfur in an organic solvent can provide a stable coating liquid. Application of this coating liquid followed by simple treatments can provide a desired sulfide semiconductor. Thus, the present invention has been completed.

The sulfide semiconductor-forming coating liquid of the present invention contains a complex containing a metal element of group 15 of the periodic table and sulfur.

Formation of such a complex leads to a stable coating liquid, which not only provides a uniform sulfide semiconductor of good quality, but also improves the electric characteristics and semiconductor properties thereof. The complex containing a metal element of group 15 of the periodic table and sulfur can be identified by measuring an absorption peak due to a bond between the metal element and sulfur by the infrared absorption spectrometry.

Preferred examples of the metal element of group 15 of the periodic table include antimony and bismuth. Antimony is more preferred because it provides a sulfide semiconductor with better electric characteristics and semiconductor properties.

The complex containing a metal element of group 15 of the periodic table and sulfur is preferably formed between the metal element of group 15 of the periodic table and a sulfur-containing compound. Since the sulfur element in the sulfur-containing compound has a lone pair of electrons not involved in the chemical bond, a coordination bond is easily formed between the sulfur element and an empty electron orbital (d or f orbital) of the metal element of group 15 of the periodic table. For this complex to be formed, the sulfide semiconductor-forming coating liquid of the present invention is preferably obtained from, at least, a metal-containing compound containing a metal element of group 15 of the periodic table, a sulfur-containing compound, and an organic solvent.

The metal-containing compound containing a metal element of group 15 of the periodic table is appropriately selected depending on the sulfur-containing compound and the organic solvent used so that a complex can be formed. Examples of the metal-containing compound containing a metal element of group 15 of the periodic table include metal salts and organometallic compounds of metal elements of group 15 of the periodic table.

Examples of the metal salt include chlorides, oxychlorides, nitrates, carbonates, sulfates, ammonium salts, borates, silicates, phosphates, hydroxides, and peroxides of metal elements of group 15 of the periodic table, and further include hydrates of these metal salts.

Examples of the organometallic compound include salt compounds of metal elements of group 15 of the periodic table with carboxylic acid, dicarboxylic acid, oligocarboxylic acid, and polycarboxylic acid. More specific examples of the organometallic compound include salt compounds of metal elements of group 15 of the periodic table with acetic acid, formic acid, propionic acid, octylic acid, stearic acid, oxalic acid, citric acid, and lactic acid.

Specific examples of the metal-containing compound containing a metal element of group 15 of the periodic table include antimony chloride, antimony acetate, antimony bromide, antimony fluoride, antimony oxyoxide, triethoxyantimony, tripropoxyantimony, bismuth nitrate, bismuth chloride, bismuth hydroxide nitrate, tris(2-methoxyphenyl)bismuth, bismuth carbonate, bismuth oxycarbonate, bismuth phosphate, bismuth bromide, triethoxybismuth, triisopropoxyantimony, arsenic iodide, and arsenic triethoxide. These metal-containing compounds containing a metal element of group 15 of the periodic table may be used alone or in combination of two or more thereof.

In the sulfide semiconductor-forming coating liquid of the present invention, the amount of the metal-containing compound containing a metal element of group 15 of the periodic table added is not particularly limited. A preferable lower limit thereof is 0.5% by weight, and a preferable upper limit is 70% by weight. When the amount is 0.5% by weight or more, a sulfide semiconductor of good quality can be readily produced. When the amount is 70% by weight or less, a stable coating liquid can be readily obtained.

The sulfur-containing compound is appropriately selected depending on the metal-containing compound containing a metal element of group 15 of the periodic table and the organic solvent used so that a complex can be formed.

Examples of the sulfur-containing compound include thiourea, derivatives of thiourea, thioacetamide, derivatives of thioacetamide, dithiocarbamates, xanthates, dithiophosphates, thiosulfates, and thiocyanates.

Examples of the derivative of thiourea include 1-acetyl-2-thiourea, ethylenethiourea, 1,3-diethyl-2-thiourea, 1,3-dimethylthiourea, tetramethylthiourea, N-methylthiourea, and 1-phenyl-2-thiourea. Examples of the dithiocarbamate include sodium dimethyldithiocarbamate, sodium diethyldithiocarbamate, potassium dimethyldithiocarbamate, and potassium diethyldithiocarbamate. Examples of the xanthate include sodium ethylxanthate, potassium ethylxanthate, sodium isopropylxanthate, and potassium isopropylxanthate. Examples of the thiosulfate include sodium thiosulfate, potassium thiosulfate, and ammonium thiosulfate. Examples of the thiocyanate include potassium thiocyanate, potassium thiocyanate, and ammonium thiocyanate. These sulfur-containing compounds may be used alone or used in combination of two or more thereof.

The amount of the sulfur-containing compound added to the sulfide semiconductor-forming coating liquid of the present invention is preferably 1 to 30 times, and more preferably 2 to 20 times the number of moles of the metal-containing compound containing a metal element of group 15 of the periodic table. When the amount is 1 or more times the number of moles of the metal-containing compound, a sulfide semiconductor having a stoichiometric proportion is more easily obtained. When the amount is 30 or less times the number of moles of the metal-containing compound, the coating liquid can have improved stability.

The organic solvent is appropriately selected depending on the metal-containing compound containing a metal element of group 15 of the periodic table and the sulfur-containing compound used so that a complex can be formed.

Examples of the organic solvent include methanol, ethanol, N,N-dimethylformamide, dimethylsulfoxide, acetone, dioxane, tetrahydrofuran, isopropanol, n-propanol, chloroform, chlorobenzene, pyridine, and toluene. Particularly preferred among these are methanol, ethanol, and acetone. These organic solvents can be used alone or in combination of two or more thereof. N,N-dimethylformamide is preferred because it provides a sulfide semiconductor having better electric characteristics and semiconductor properties.

The sulfide semiconductor-forming coating liquid of the present invention may further contain a non-organic solvent component such as water to the extent that it does not impair the effect of the present invention.

Specific examples of the complex containing a metal element of group 15 of the periodic table and sulfur include a bismuth-thiourea complex, a bismuth-thiosulfuric acid complex, a bismuth-thiocyanic acid complex, an antimony-thiourea complex, an antimony-thiosulfuric acid complex, an antimony-thiocyanic acid complex, an antimony-dithiocarbamic acid complex, and an antimony-xanthic acid complex.

The present invention also includes a sulfide semiconductor thin film produced by applying the sulfide semiconductor-forming coating liquid of the present invention to a substrate. The thin film of a sulfide semiconductor obtained in this manner is useful as a solar cell material, a photocatalyst material, or a photoconductive material.

The method of applying the sulfide semiconductor-forming coating liquid of the present invention is not particularly limited. Examples of the method include printing methods such as the spin coat method and the roll-to-roll method. Use of the sulfide semiconductor-forming coating liquid of the present invention enables printing methods to be employed, so that a uniform and smooth sulfide semiconductor thin film can be formed. This can improve the electric characteristics and semiconductor properties of the sulfide semiconductor thin film and reduce the cost of the film formation.

The present invention also includes a thin film solar cell including a sulfide semiconductor produced using the sulfide semiconductor-forming coating liquid of the present invention, the sulfide semiconductor serving as a photoelectric conversion layer.

It is preferable that the photoelectric conversion layer further includes an organic semiconductor adjacent to the sulfide semiconductor. In this case, the positional relation between the sulfide semiconductor and the organic semiconductor in the photoelectric conversion layer is not particularly limited as long as these semiconductors are adjacent to each other. The conversion layer may be a laminate including a sulfide semiconductor layer and an organic semiconductor layer, or alternatively it may be a composite film obtained from a mixture of a sulfide semiconductor and an organic semiconductor.

The laminate including a sulfide semiconductor layer and an organic semiconductor layer may be produced by laminating an organic semiconductor thin film layer on a sulfide semiconductor thin film layer produced from the sulfide semiconductor-forming coating liquid of the present invention. Alternatively, the sulfide semiconductor thin film layer may be laminated on the organic semiconductor thin film layer.

The composite film obtained from a mixture of a sulfide semiconductor and an organic semiconductor may be produced by, for example, applying a mixture of the sulfide semiconductor-forming coating liquid of the present invention and an organic semiconductor to a substrate.

The organic semiconductor is not particularly limited, and examples thereof include: thiophene derivatives such as poly(3-alkylthiophene); conductive polymers such as polyparaphenylenevinylene derivatives, polyvinyl carbazole derivatives, polyaniline derivatives, and polyacetylene derivatives; phthalocyanine derivatives; naphthalocyanine derivatives; pentacene derivatives; and porphyrin derivatives such as benzoporphyrin derivatives. Preferred among these are thiophene derivatives, phthalocyanine derivatives, naphthalocyanine derivatives, and benzoporphyrin derivatives because these have relatively high durability.

The thin film solar cell of the present invention may further include, in addition to the photoelectric conversion layer, a substrate, a hole transporting layer, an electron transporting layer, and the like. The substrate is not particularly limited, and examples thereof include transparent glass substrates such as soda-lime glass substrates and alkali-free glass substrates, ceramic substrates, and transparent plastic substrates.

The material of the hole transporting layer is not particularly limited, and examples thereof include P-type conductive polymers, P-type low-molecular organic semiconductors, P-type metal oxides, P-type metal sulfides, and surfactants. Specific examples thereof include polystyrene sulfonate-doped polyethylene dioxythiophene, carboxy group-containing polythiophene, phthalocyanine, porphyrin, fluoro-group containing phosphonic acid, carbonyl group-containing phosphonic acid, molybdenum oxide, vanadium oxide, tungsten oxide, nickel oxide, copper oxide, tin oxide, molybdenum sulfide, tungsten sulfide, copper sulfide, and tin sulfide.

The material of the electron transporting layer is not particularly limited, and examples thereof include N-type conductive polymers, N-type low-molecular organic semiconductors, N-type metal oxides, N-type metal sulfides, halogenated alkali metals, alkali metals, and surfactants. Specific examples thereof include cyano group-containing polyphenylenevinylene, boron-containing polymers, bathocuproine, bathophenanthrene, hydroxyquinolinatoaluminum, oxadiazole compounds, benzimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

### - Advantageous Effects of Invention

The present invention provides a sulfide semiconductor-forming coating liquid capable of easily forming a sulfide semiconductor having a large area, the sulfide semiconductor being useful as a semiconductor material for photoelectric conversion materials. The present invention also provides a sulfide semiconductor thin film produced from the sulfide semiconductor-forming coating liquid; and a thin film solar cell.

### DESCRIPTION OF EMBODIMENT

In the following, the present invention will be described in more detail based on, but not limited to, examples.

### (Example 1)

### (Preparation of sulfide semiconductor-forming coating liquid)

Antimony (III) chloride (20 parts by weight) was mixed with methanol (100 parts by weight) and then dissolved therein by stirring. Subsequently, thiourea (CS(NH₂)₂) (13.5 parts by weight) was slowly added with stirring to the solution of antimony (III) chloride in methanol. The color of the solution was clear and colorless before mixing, and changed to clear yellow during the addition of thiourea. After the addition, the mixture was stirred for additional 30 minutes. Thereby, a coating liquid for forming antimony sulfide was prepared.

The infrared absorption spectrum of the obtained coating liquid for forming antimony sulfide was measured. The three positions (3370 cm⁻¹, 3290 cm⁻¹, 3148 cm⁻¹) of absorption peaks due to -NH₂ stretching vibration were the same as the positions of the absorption peaks due to -NH₂ of thiourea alone. The spectrum of the thiourea alone showed a single absorption peak (1413 cm⁻¹) due to the C=S bond. On the other hand, the peak due to the C=S bond in the case of the coating liquid for forming antimony sulfide split into two peaks. The absorption peak due to C-N stretching vibration shifted from 1474 cm⁻¹ to 1511 cm⁻¹.

These results shows that a complex was formed between antimony and thiourea in the coating liquid for forming antimony sulfide, and that the complex was formed between an antimony atom and a sulfur atom in the thiourea, not between the antimony atom and a nitrogen atom of thiourea.

### (Formation of sulfide semiconductor thin film)

The coating liquid for forming antimony sulfide was applied to an ITO glass substrate (thickness of ITO film: 240 nm) by the spin coat method at a rotation number of 3000 rpm. After the application, the coated substrate was allowed to stand for 10 minutes at a room temperature and then dried at 70°C for 5 minutes. The color of the dried film was nearly clear and colorless. Thereafter the sample was placed in a vacuum furnace and fired at 260°C for 10 minutes while vacuumizing the furnace. Thereby an antimony sulfide thin film was obtained. The film taken out from the furnace was black. The fired film was subjected to ultrasonic cleaning with methanol for 5 minutes, and thereafter physical properties of the film were evaluated.

The average film thickness of the film was measured with a film thickness meter (KLA-TENCOR, P-16+) and found to be 120 nm. Also, the absorption spectrum of the film was measured with a spectral photometer (a product of Hitachi High-Technologies Corporation, U-4100), and the band gap was estimated from the spectrum to be 1. 7 eV. The film was further subjected to a thin film X-ray diffraction analysis (device: RINT-Ultima III). The result of the analysis showed that the film was a crystal film having a stibnite structure. Observation of the shape of the film surface with a light microscope and a laser microscope showed a smooth and uniform surface.

### (Preparation of thin film solar cell)

A film (film thickness: 100 nm) of poly(3-alkylthiophene) (P3HT) as a P-type semiconductor layer was formed on the obtained antimony sulfide thin film by the spin coat method. Subsequently, a film (thickness: 100 nm) of poly(ethylenedioxidethiophene):polystyrene sulfonate (PEDOT:PSS) as a hole transporting layer was formed by the spin coat method. A gold electrode (thickness: 80 nm) was then formed on the surface of the film by the vacuum deposition method. Thereby, a thin film solar cell was prepared.

### (Example 2)

A sulfide semiconductor-forming coating liquid, a sulfide semiconductor thin film, and a thin film solar cell were prepared in the same manner as in Example 1 except that antimony(III) acetate was used instead of antimony(III) chloride. The physical properties of the sulfide semiconductor thin film were also evaluated in the same manner as in Example 1.

The infrared absorption spectrum of the resulting sulfide semiconductor-forming coating liquid was measured and it was found that a complex was formed between antimony and thiourea.

### (Example 3)

A sulfide semiconductor-forming coating liquid, a sulfide semiconductor thin film, and a thin film solar cell were prepared in the same manner as in Example 1 except that sodium thiosulfate was used instead of thiourea. The physical properties of the sulfide semiconductor thin film were also evaluated in the same manner as in Example 1.

The infrared absorption spectrum of the resulting sulfide semiconductor-forming coating liquid was measured and it was found that a complex was formed between antimony and thiosulfuric acid.

### (Example 4)

A sulfide semiconductor-forming coating liquid, a sulfide semiconductor thin film, and a thin film solar cell were prepared in the same manner as in Example 1 except that potassium thiocyanate was used instead of thiourea. The physical properties of the sulfide semiconductor thin film were also evaluated in the same manner as in Example 1.

The infrared absorption spectrum of the resulting sulfide semiconductor-forming coating liquid was measured and it was found that a complex was formed between antimony and thiocyanic acid.

### (Example 5)

A sulfide semiconductor-forming coating liquid, a sulfide semiconductor thin film, and a thin film solar cell were prepared in the same manner as in Example 1 except that isopropanol was used as the solvent instead of methanol. The physical properties of the sulfide semiconductor thin film were also evaluated in the same manner as in Example 1.

The infrared absorption spectrum of the resulting sulfide semiconductor-forming coating liquid was measured and it was found that a complex was formed between antimony and thiourea.

### (Example 6)

A sulfide semiconductor-forming coating liquid, a sulfide semiconductor thin film, and a thin film solar cell were prepared in the same manner as in Example 1 except that N,N-dimethylformamide was used as the solvent instead of methanol. The physical properties of the sulfide semiconductor thin film were also evaluated in the same manner as in Example 1.

The infrared absorption spectrum of the resulting sulfide semiconductor-forming coating liquid was measured and it was found that a complex was formed between antimony and thiourea.

### (Example 7)

A sulfide semiconductor-forming coating liquid, a sulfide semiconductor thin film, and a thin film solar cell were prepared in the same manner as in Example 1 except that bismuth(III) nitrate was used instead of antimony (III) chloride. The physical properties of the sulfide semiconductor thin film were also evaluated in the same manner as in Example 1.

The infrared absorption spectrum of the resulting sulfide semiconductor-forming coating liquid was measured and it was found that a complex was formed between bismuth and thiourea.

### (Example 8)

A sulfide semiconductor-forming coating liquid, a sulfide semiconductor thin film, and a thin film solar cell were prepared in the same manner as in Example 1 except that potassium ethylxanthate was used instead of thiourea, toluene was used as the solvent instead of methanol, and the fire temperature was 200°C, not 260°C. The physical properties of the sulfide semiconductor thin film were also evaluated in the same manner as in Example 1.

The infrared absorption spectrum of the resulting sulfide semiconductor-forming coating liquid was measured and it was found that a complex was formed between antimony and ethylxanthic acid.

### (Comparative Example 1)

A sulfide semiconductor-forming coating liquid, a sulfide semiconductor thin film, and a thin film solar cell were prepared in the same manner as in Example 1 except that sodium sulfide was used instead of thiourea. The physical properties of the sulfide semiconductor thin film were also evaluated in the same manner as in Example 1.

The obtained sulfide semiconductor-forming coating liquid was not a transparent liquid, but a yellow cloudy liquid in which precipitation was likely to occur. Infrared absorption spectrum and X-ray fluorescence measurement of the yellow cloudy component revealed that the component was antimony sulfide. Thus it was confirmed that, when sodium sulfide is used, no complex is formed and antimony chloride is directly reacted with sodium sulfide to provide antimony sulfide in the sulfide semiconductor-forming coating liquid.

### (Comparative Example 2)

A sulfide semiconductor-forming coating liquid, a sulfide semiconductor thin film, and a thin film solar cell were prepared in the same manner as in Example 1 except that water was used as the solvent instead of methanol. The physical properties of the sulfide semiconductor thin film were also evaluated in the same manner as in Example 1.

The obtained sulfide semiconductor-forming coating liquid was not a transparent liquid, but a white cloudy liquid. Infrared absorption spectrum and X-ray fluorescence measurement of the white cloudy component revealed that the component was antimony oxide. This formation of antimony oxide is presumably attributed to the antimony chloride as a raw material being prone to hydrolyze in water.

### (Evaluation)

The resultant thin film solar cells were subjected to the following evaluation.

### (Evaluation of solar cell properties)

A power source (a product of KEITHLEY, model: 236) was connected between electrodes of each of the thin film solar cells obtained in the examples and comparative examples. The energy conversion efficiency of the solar cell was measured with a solar simulator (a product of Yamashita Denso Corporation) having a irradiation intensity of 100 mW/cm². The measured values were standardized with respect to the energy conversion efficiency of the solar cell of Comparative Example 1 taken as 1.0. The results are shown in Table 1.

**[Table 1]**

| | Composition of coating liquid | | | | Physical properties of film | | | | Solar cell properties |
|---|---|---|---|---|---|---|---|---|---|
| | Metal-containing compound | Sulfur-containing compound | Solvent | Complex formation | Average film thickness (nm) | Band gap (eV) | Crystallinity | Film quality (shape of the film surface) | Relative conversion efficiency (relative to Comparative Example 1) |
| Example 1 | SbCl₃ | Thiourea | Methanol | Antimony-thiourea | 120 | 1.7 | Crystaline | Smooth, uniform | 10.5 |
| Example 2 | Sb(CH₃COO)₃ | Thiourea | Methanol | Antimony-thiourea | 80 | 1.7 | Crystaline | Smooth, uniform | 9.6 |
| Example 3 | SbCl₃ | Sodium thiosulfate | Methanol | Antimony-thiosulfuric acid | 70 | 1.7 | Crystaline | Smooth, uniform | 8.7 |
| Example 4 | SbCl₃ | Potassium thiocyanate | Methanol | Antimony-thiocyanic acid | 110 | 1.8 | Crystaline | Smooth, uniform | 7.9 |
| Example 5 | SbCl₃ | Thiourea | Isopropanol | Antimony-thiourea | 130 | 1.7 | Crystaline | Smooth, uniform | 9.1 |
| Example 6 | SbCl₃ | Thiourea | N,N-dimethylformamide | Antimony-thiourea | 120 | 1.7 | Crystaline | Smooth, uniform | 12.8 |
| Example 7 | Bi(NO₃)₃ | Thiourea | Methanol | Bismuth-thiourea | 90 | 1.3 | Crystaline | Smooth, uniform | 3.3 |
| Example 8 | SbCl₃ | Potassium ethylxanthate | Toluene | Antimony-ethylxanthic acid | 100 | 1.7 | Crystaline | Smooth, uniform | 112 |
| Comparative Example 1 | SbCl₃ | Sodium sulfide | Methanol | none | 105 | 1.7 | Crystaline | Rough, non-uniform | 1.0 |
| Comparative Example 2 | SbCl₃ | Thiourea | Water | none | 210 | 3.3 | Amorphous | Rough, non-uniform | 0.1 |

### INDUSTRIAL APPLICABILITY

According to the present invention, a sulfide semiconductor-forming coating liquid capable of easily forming a sulfide semiconductor having a large area is provided, the sulfide semiconductor being useful as a semiconductor material for photoelectric conversion materials. Also provided are a sulfide semiconductor thin film produced using the sulfide semiconductor-forming coating liquid; and a thin film solar cell.

## Claims

1. A sulfide semiconductor-forming coating liquid, comprising
a complex containing a metal element of group 15 of the periodic table and sulfur.

2. The coating liquid according to claim 1, obtained from at least a metal-containing compound containing a metal element of group 15 of the periodic table, a sulfur-containing compound, and an organic solvent.

3. A sulfide semiconductor thin film produced by applying, to a substrate, the sulfide semiconductor-forming coating liquid according to claim 1 or 2.

4. A thin film solar cell, comprising a sulfide semiconductor produced using the sulfide semiconductor-forming coating liquid according to claim 1 or 2,
the sulfide semiconductor serving as a photoelectric conversion layer.

5. The thin film solar cell according to claim 4,
wherein the photoelectric conversion layer further comprises an organic semiconductor adjacent to the sulfide semiconductor.
